# EUROPEAN PATENT SPECIFICATION

(11) **EP 1 589 582 B1**
(45) Date of publication and mention of the grant of the patent: **08.10.2008**
(21) Application number: 04700774.5
(22) Date of filing: 08.01.2004
(51) Int. Cl.: H01L 27/146, G01T 1/20, G01T 1/24

(54) **WIRING SUBSTRATE AND RADIATION DETECTOR USING SAME**
VERDRAHTUNGSSUBSTRAT UND STRAHLUNGSDETEKTOR DAMIT
SUBSTRAT DE CABLAGE ET DETECTEUR DE RAYONNEMENT UTILISANT CELUI-CI

(30) Priority: 08.01.2003 JP 2003002541
(43) Date of publication of application: 26.10.2005
(73) Proprietor: HAMAMATSU PHOTONICS K.K., Hamamatsu-shi, Shizuoka-ken 435-8558 (JP)
(72) Inventor: SHIBAYAMA, Katsumi c/o Hamamatsu Photonics K.K., 4358558 (JP); KUSUYAMA, Yutaka c/o Hamamatsu Photonics K.K., 4358558 (JP); HAYASHI, Masahiro c/o Hamamatsu Photonics K.K., 4358558 (JP)
(74) Representative: Frost, Alex John
(86) International application number: PCT/JP2004/000079
(87) International publication number: WO 2004/064163

(56) References cited:
- EP-A- 1 492 168
- WO-A-91/10921
- JP-A- 10 056 040
- JP-A- 2002 359 446
- JP-A- 2003 264 280
- JP-A- 2003 282 849
- US-A1- 2002 038 851

## Description

### Technical Field

This invention concerns a wiring substrate, provided with a conduction path that guide an electrical signal, and a radiation detector using the same.

### Background Art

As a radiation detector for use as a CT sensor, etc., there is a detector of an arrangement wherein a scintillator is disposed on a light-incident surface of a semiconductor photodetecting element array, such as a photodiode array. With such a radiation detector, when an X-ray, γ-ray, charged particle beam, or other radiation to be detected is made incident on the scintillator, scintillation light is generated inside the scintillator by the radiation. This scintillation light is then detected by means of the semiconductor photodetecting elements to thereby detect the radiation.

Also, in order to perform signal processing of the detected signals output from the respective photodetecting elements of the photodetecting element array, a signal processing element is provided. As an arrangement for electrically connecting the photodetecting elements with the signal processing element, an arrangement wherein connections are made by various wirings, an arrangement wherein connections are made via conduction paths provided at a wiring substrate, etc., may be used (see for example, Japanese Patent Application Laid-Open No. JP-A-8330469).

EP-A-1492168 relates to a semiconductor chip formed with a plurality of photodiodes equipped with a scintillator for X-ray detection. The circuit substrate comprises a plurality of input terminals, to which signals from the output terminals of the semiconductor chip are inputted. The circuit substrate comprises a first and a second wiring substrates with conductive member disposed in the through hole. The conductive members of both wiring substrates are electrically connected with a bump electrode. The first wiring substrate is made of glass, whereas the second wiring substrate is made from ceramic. A signal reading circuit is formed on the circuit substrate on the side opposite to the semiconductor chip. The dimensions of the circuit substrate can then advantageously be made smaller than those of the semiconductor chip.

WO-A-91110921 relates to an X-ray detector, having sensor arrays that are connected to pre-processor arrays. A scintillator, for example a glass plate doped with phosphor, is positioned between the sensing arrays and the pre-processing circuits. A hole is drilled through the scintillator and solder bumps are provided on the sensor array and pre-processor arrays, such that gold or silver connectors can fill the hole in the scintillator to connect the solder bumps together. This provides connection between the sensor array and pre-processor arrays.

JP-A-2003/282849 describes a radiographic detector comprising a photoelectric transfer device and a connection board. The connection board base is provided with a plurality of openings. Radiographic shading electrodes are embedded in these openings. These are arranged so that X-rays can pass through the photoelectric transfer device, and reach the connection board, but are shaded by the radiographic shading electrodes such that they do not reach most of the regions of an electric charge transfer circuit.

US-A-2002/038851 describes a fiber plate, which comprises the plurality of individual fiber plates of the same thickness. This provides a light guiding plane larger in area than the light guiding plane of each individual fiber plate. A radiation image pickup apparatus is also provided using the fiber plate, wherein each of the plurality of individual fiber plates comprises a group of optical fibers having mutually parallel axes, and the lateral faces of the plurality of individual fiber plates are mutually bonded such that the axes of the optical fibers thereof become mutually parallel.

### Disclosure of the Invention

Normally with the above-mentioned radiation detector, a part of the radiation that is made incident on the scintillator is transmitted through the scintillator and the photodetecting element array. Meanwhile, with an arrangement wherein the scintillator, photodetecting element array, wiring substrate, and signal processing element are positioned along a predetermined alignment direction, the radiation that is transmitted through the scintillator, etc., becomes incident, via the wiring substrate, on the signal processing element at the downstream side in the alignment direction. When radiation is thus made incident on the signal processing element, the signal processing element undergoes radiation damage, thus causing degradation of the reliability and life of the radiation detector.

This invention has been made to resolve the above problem and an object thereof is to provide a wiring substrate, with which the transmission of radiation is restrained, and a radiation detector using such a wiring substrate.

In order to achieve the above object, this invention provides in a wiring substrate, having a conduction path that guide an electrical signal between a signal input surface and a signal output surface, a wiring substrate (1) comprising at least a first wiring substrate, disposed at the signal input surface side, and a second wiring substrate, connected to the first wiring substrate at the signal output surface side, with each wiring substrate respectively comprising a glass substrate, formed of a glass material having a radiation shielding function and provided with a through hole, and a conductive member, disposed in the through hole and functioning as the conduction path that provide electrical connection between the input surface and the output surface, and (2) wherein as viewed in the conduction direction from the signal input surface to the signal output surface, the position of the through hole in the first wiring substrate differs from the position of the through hole in the second wiring substrat, and wherein the conductive member in the first wiring substrate is electically connected to the conductive member in the second wiring substrate by a bump electrode.

With the above-described wiring substrate, the wiring substrate used for electrically connecting a radiation detecting means and a signal processing means in a radiation detector, etc., is arranged by two wiring substrates having glass substrates. And in regard to the through hole of the conduction path that is provided in each of the first and second wiring substrates, the through holes are provided at mutually different positions.

With such an arrangement, at portions at which there are no through holes in the first and second wiring substrates, the transmission of radiation from the signal input surface to the signal output surface is restrained by the glass material. Also, with this arrangement, even at portions where there is a through hole at just one of either the first or second wire substrate, there is no through hole at the other wiring substrate. Thus at all positions of the wiring substrate, the glass material with radiation shielding function exists at least at one of the two wiring substrates. A wiring substrate is thereby realized with which the transmission of radiation is restrained as a whole.

In regard to the glass material used in the wiring substrate, each of the first wiring substrate and the second wiring substrate is preferably formed of a glass material that contains lead. The transmittance of radiation through the wiring substrate can thereby be restrained effectively. Also, substrates formed of other glass materials with radiation shielding function may be used instead.

In regard to the arrangement of the conduction paths of the wiring substrate, the conductive member of each of the first wiring substrate and the second wiring substrate may be formed on the inner wall of the through hole provided in the glass substrate. Or, the conductive member may be provided by filling the interior of the through hole provided in the glass substrate. By using such conductive members as conduction paths, electrical signals can be transmitted favorably between the signal input surface and the signal output surface.

Preferably, the glass substrate of each of the first wiring substrate and the second wiring substrate is a glass substrate wherein a plurality of through holes are provided by fusing together and integrally forming a plurality of hollow glass members that are open at both ends. A substrate of an arrangement besides this may also be used.

This invention's radiation detector comprises: (1) a radiation detecting means, outputting a detected signal upon detecting radiation made incident thereon; (2) a signal processing means, processing the detected signal from the radiation detecting means; and (3) a wiring substrate section, which has the above-described wiring substrate provided with the conduction path that guide the detected signal between the signal input surface and the signal output surface and with which the radiation detecting means and the signal processing means are connected to the signal input surface and the signal output surface, respectively; and (4) wherein the radiation detecting means, the wiring substrate section, and the signal processing means are positioned in that order along a predetermined alignment direction that matches the conduction direction in the wiring substrate.

With the above-described radiation detector, the wiring substrate of the above-described arrangement, having the first and second wiring substrates, is used as the wiring substrate section that electrically connects the radiation detecting means and the signal processing means and transmits the detected signal, which is the electrical signal. With such an arrangement, at all positions of the wiring substrate section, the glass material with radiation shielding function exists at least at one of the two wiring substrates. A radiation detector is thus realized wherein radiation is prevented from becoming incident on the signal processing element and degradation of the reliability and life due to radiation damage is restrained.

In regard to the arrangement of the radiation detecting means, an arrangement having a scintillator, which generates scintillation light upon incidence of radiation, and a semiconductor photodetecting element, which detects the scintillation light from the scintillator, can be used as the radiation detecting means. Also, an arrangement, having a semiconductor detecting element that detects radiation made incident thereon, may be used instead.

Preferably, at least one of either the combination of the wiring substrate section and the radiation detecting means or the combination of the wiring substrate section and the signal processing means is electrically connected via a bump electrode. By using such metal bump electrodes as the electrical connection means, the respective components can be electrically connected favorably.

### Brief Description of the Drawings

Fig. 1 is a sectional side view showing the cross-sectional structure of an embodiment of a wiring substrate and a radiation detector using the wiring substrate.

Fig. 2 is a perspective view showing the arrangement of the radiation detector of Fig. 1 in an exploded manner.

Fig. 3A and Fig. 3B are plan views respectively showing the arrangement of (A) a signal input surface and (B) a signal output surface of a first wiring substrate.

Fig. 4A and Fig. 4B are plan views respectively showing the arrangement of (A) a signal input surface and (B) a signal output surface of a second wiring substrate.

Fig. 5A to Fig. 5C are drawings showing an example of a glass substrate provided with a plurality of through holes.

Fig. 6A and Fig. 6B are drawings showing an example of the arrangement of a conductive member disposed at a through hole of a wiring substrate.

Fig. 7A and Fig. 7B are drawings showing another example of the arrangement of a conductive member disposed at a through hole of a wiring substrate.

### Best Mode for Carrying out the Invention

Preferred embodiments of this invention's wiring substrate and radiation detector using the same shall now be described in detail along with the drawings. In the description of the drawings, the same elements shall be provided with the same symbols and overlapping description shall be omitted. Also, the dimensional proportions of the drawings do not necessary match those of the description.

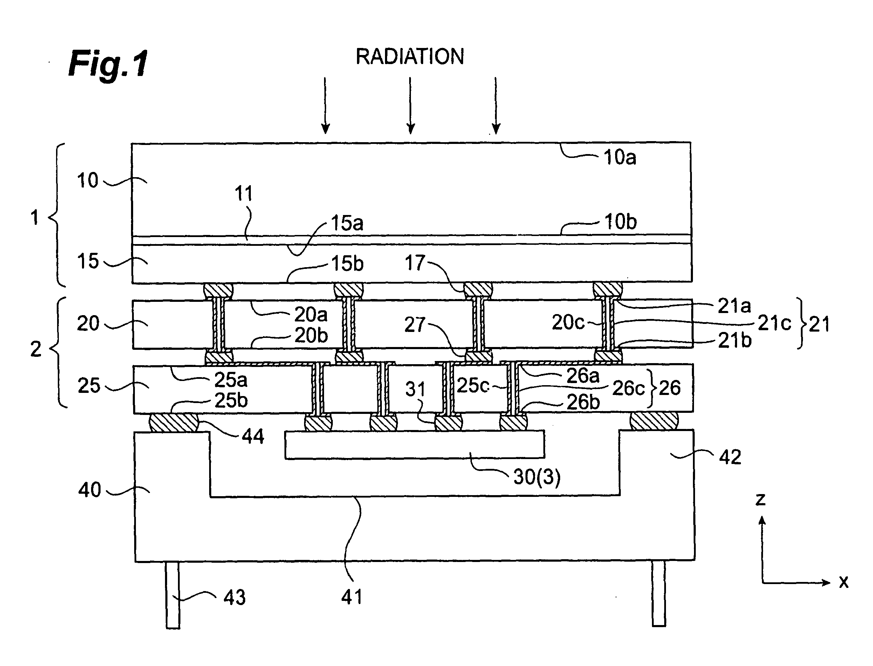

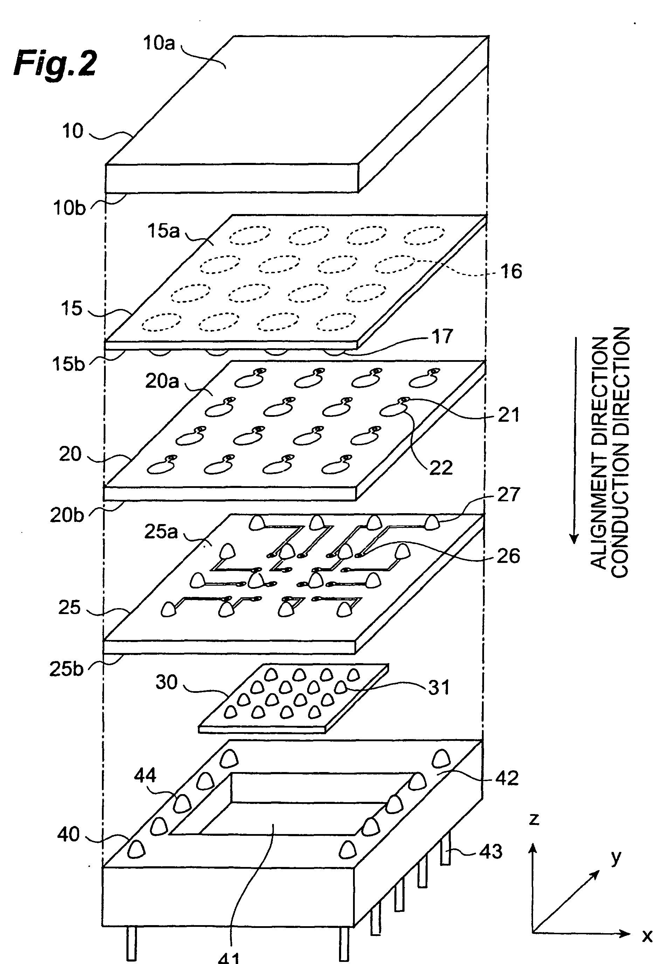

Fig. 1 is a sectional side view showing the cross-sectional structure of an embodiment of this invention's wiring substrate and radiation detector. Fig. 2 is a perspective view showing the arrangement of the wiring substrate and the radiation detector shown in Fig. 1 with the respective components being shown in exploded manner. As shown in Fig. 1 and Fig. 2, for the convenience of description, an axis along the direction of incidence of radiation shall be taken as the z-axis and two axes orthogonal to the z-axis shall be taken as the x-axis and the y-axis in the description that follows. Here, the negative direction of the z-axis is the conduction direction from a signal input surface to a signal output surface of the wiring substrate and is the alignment direction of the respective components of the radiation detector.

The radiation detector shown in Fig. 1 is provided with a radiation detecting section 1, a wiring substrate section 2, and a signal processing section 3. As shown in Fig. 2, these are positioned in that order from the upstream side (upper side of the figure) to the downstream side (lower side) along the predetermined alignment direction.

Radiation detecting section 1 is a detecting means that detects an X-ray, γ-ray, charged particle beam, or other radiation that is made incident as the object of detection on the present radiation detector and outputs detected signals, which are electrical signals corresponding to the incident radiation. With the present embodiment, radiation detecting section 1 is arranged as having a .scintillator 10 and a photodiode array 15.

Scintillator 10 comprises an upstream side portion of radiation detecting section 1 and its upper surface 10a is a radiation incidence surface of the present radiation detector. This scintillator 10 generates scintillation light of a predetermined wavelength upon incidence of radiation from incidence surface 10a.

Photodiode array (PD array) 15 comprises a downstream side portion of radiation detecting section 1. This PD array 15 is a photodetecting element array wherein a plurality of photodiodes (PDs), which are semiconductor photodetecting elements that detect the scintillation light from scintillator 10, are arrayed. A light exit surface 10b, which is the lower surface of scintillator 10, and a light-incident surface 15a, which is the upper surface of PD array 15, are optically connected via an optical adhesive agent 11, through which the scintillation light is transmitted.

As an arrangement example of PD array 15, a PD array, wherein 4 × 4 = 16 photodiodes 16 are arrayed in two dimensions with the x-axis and the y-axis as the alignment axes, is shown in Fig. 2. A lower surface 15b of PD array 15 is a signal output surface for outputting detected signals from the respective photodiodes 16. At this lower surface 15b, 16 bump electrodes 17, which are detected signal output electrodes, are arrayed in a 4 × 4 manner in correspondence with the respective photodiodes 16. Though not illustrated in particular, bump electrodes that serve as common electrodes of the photodiodes are also provided.

Wiring substrate section 2 is positioned at the downstream side of radiation detecting section 1. With the present embodiment, wiring substrate section 2 is arranged with a wiring substrate, formed by layering the two wiring substrates of a first wiring substrate 20 and a second wiring substrate 25 and provided with conduction paths that guide electrical signals between the signal input surface and the signal output surface. With each of these wiring substrates 20 and 25, a glass substrate, formed of a predetermined glass material having a radiation shielding function, is used as the substrate. As such a glass material, for example, lead glass, which contains lead, is preferably used.

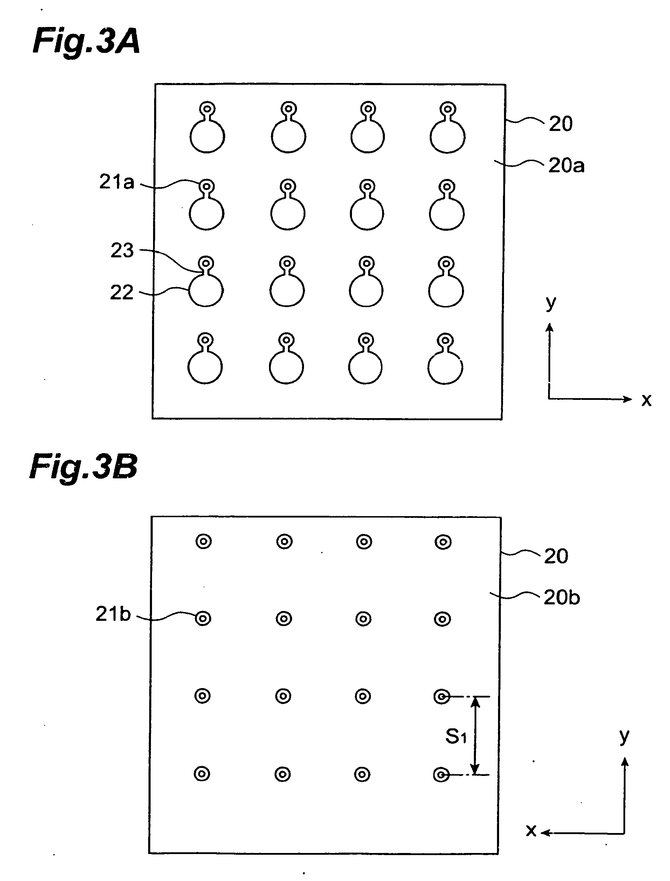

First wiring substrate 20 comprises an upstream side portion of the wiring substrate used in wiring substrate section 2. Fig. 3A and Fig. 3B are plan views showing the arrangement of first wiring substrate 20, with Fig. 3A showing an input surface 20a, which is the upper surface, and Fig. 3B showing an output surface 20b, which is the lower surface. With this first wiring substrate 20, input surface 20a is the signal input surface for wiring substrate section 2 as a whole.

In the glass substrate that comprises first wiring substrate 20, a plurality of through holes 20c are formed between input surface 20a and output surface 20b. At each through hole 20c is disposed a conductive member 21, which provides electrical connection between input surface 20a and output surface 20b and functions as a conduction path. In the present embodiment, 4 × 4 = 16 through holes 20c and conductive members 21 are provided in correspondence with the arrangement of PD array 15. As shown in Fig. 3B, these through holes 20c and conductive members 21 are formed at the same pitch S₁ as bump electrodes 17 on PD array 15. Though not illustrated in particular, through holes and conductive members are also provided for the common electrodes of the photodiodes.

Specifically, each conductive member 21 is arranged by a conducting portion 21c, which is formed in the interior of a through hole 20c, an input portion 21a, which is formed on input surface 20a at an outer peripheral portion of through hole 20c so as to be continuous with conducting portion 21c, and an output portion 21b, which is formed on output surface 20b at an outer peripheral portion of through hole 20c so as to be continuous with conducting portion 21c.

As shown in Fig. 3A, in addition to input portions 21a of conductive members 21, electrode pads 22 are formed on input surface 20a of first wiring substrate 20. These electrode pads 22 are provided at positions corresponding to bump electrodes 17 on output surface 15b of PD array 15. Electrode pads 22 are also electrically connected via wirings 23 to input portions 21a of the corresponding conductive members 21. Photodiodes 16, which are the parts of PD array 15 that output the detected signals, are thus electrically connected via bump electrodes 17 and electrode pads 22 to conductive members 21, which are the conduction paths of first wiring substrate 20. Though not illustrated in particular, electrode pads for the common electrodes of the photodiodes are also provided.

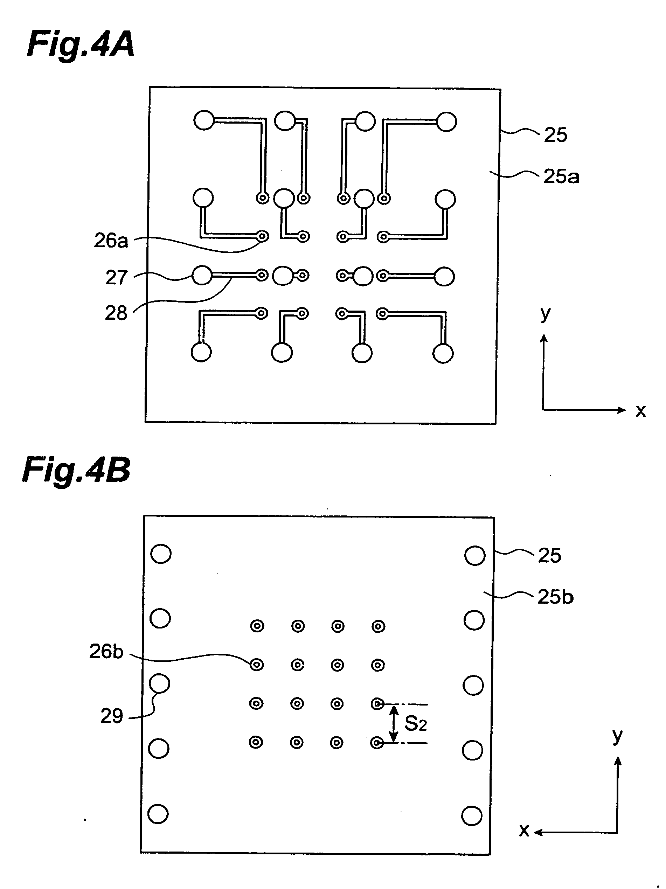

Meanwhile, second wiring substrate 25 comprises a downstream side portion of the wiring substrate used in wiring substrate section 2. Here, Fig. 4A and Fig. 4B are plan views showing the arrangement of second wiring substrate 25, with Fig. 4A showing an input surface 25a, which is the upper surface, and Fig. 4B showing an output surface 25b, which is the lower surface. With this second wiring substrate 25, output surface 25b is the signal output surface for wiring substrate section 2 as a whole.

In the glass substrate that comprises second wiring substrate 25, a plurality of through holes 25c are formed between input surface 25a and output surface 25b. At each through hole 25c is disposed a conductive member 26, which provides electrical connection between input surface 25a and output surface 25b and functions as a conduction path. In the present embodiment, similar to first wiring substrate 20, 4 × 4 = 16 through holes 25c and conductive members 26 are provided in correspondence with the arrangement of PD array 15. Though not illustrated in particular, through holes and conductive members are also provided for the common electrodes of the photodiodes.

Here, unlike bump electrodes 17 of PD array 15 and through holes 20c and conductive members 21 of first wiring substrate 20, through holes 25c and conductive members 26 are formed at a pitch S₂, which is smaller than the pitch S₁ as shown in Fig. 4B. The wiring substrate of wiring substrate section 2, which comprises first wiring substrate 20 and second wiring substrate 25, is thus provided with an arrangement wherein, in the view in the conduction direction from the signal input surface to the signal output surface and perpendicular to these surfaces, the positions of the through holes 20c in first wiring substrate 20 differ from the positions of the through holes 25c in second wiring substrate 25. As shown in Fig. 2, the conduction direction in the wiring substrate is substantially matched to the alignment direction of the respective components of the radiation detector.

Specifically, each conductive member 26 is arranged by a conducting portion 26c, which is formed in the interior of a through hole 25c, an input portion 26a, which is formed on input surface 25a at an outer peripheral portion of through hole 25c so as to be continuous with conducting portion 26c, and an output portion 26b, which is formed on output surface 25b at an outer peripheral portion of through hole 25c so as to be continuous with conducting portion 26c.

As shown in Fig. 4A, in addition to input portions 26a of conductive members 26, bump electrodes 27 are formed on input surface 25a of second wiring substrate 25. These bump electrodes 27 are provided at positions corresponding to output portions 21b on output surface 20b of first wiring substrate 20. Bump electrodes 27 are also electrically connected via wirings 28 to input portions 26a of the corresponding conductive members 26. Conductive members 21, which are the conduction paths that transmit the detected signals at first wiring substrate 20, are thus electrically connected via output portions 21b and bump electrodes 27 to conductive members 26, which are the conduction paths of second wiring substrate 25. Though not illustrated in particular, bump electrodes for the common electrodes of the photodiodes are also provided.

On output surface 25b of second wiring substrate 25, electrode pads 29 are formed in addition to output portions 26b of conductive members 26 as shown in Fig. 4B. These electrode pads 29 are used for connection with a housing 40 to be described later. Though not illustrated in particular, electrode pads for the common electrodes of the photodiodes are also provided.

Signal processing section 3 and housing (package) 40 are disposed at the downstream side of wiring substrate section 2. In the present embodiment, signal processing section 3 comprises a signal processing element 30, which is provided with a signal processing circuit for processing detected signals from PD array 15 of radiation detecting section 1.

Bump electrodes 31 are formed on the upper surface of signal processing element 30. These bump electrodes 31 are disposed at positions corresponding to output portions 26b on output surface 25b of second wiring substrate 25. Conductive members 26, which are the conduction paths of second wiring substrate 25 that transmit the detected signals, are thereby electrically connected via output portions 26b and bump electrodes 31 to the signal processing circuit provided in signal processing element 30.

Housing 40 is a holding member that integrally holds radiation detecting section 1, wiring substrate section 2, and signal processing section 3. Housing 40 has an element housing part 41, which is provided as a recessed part on the upper surface of the housing and houses signal processing element 30 in the interior thereof, and a supporting part 42, which is disposed at the outer periphery of element housing part 41, is connected via bump electrodes 44 to electrode pads 29 of second wiring substrate 25, and supports radiation detecting section 1, wiring substrate section 2, and signal processing section 3. Leads 43, used for input and output of electrical signals with respect to the exterior, are provided on the lower surface of housing 40.

With the above-described arrangement, when an X-ray or other radiation is made incident on scintillator 10 of radiation detecting section 1, scintillation light is generated in scintillator 10 by the radiation and is made incident, via optical adhesive agent 11, onto photodiodes 16 of PD array 15. Photodiodes 16 detect the scintillation light and output detected signals, which are electrical signals corresponding to the detection of the radiation.

The detected signals output from the respective photodiodes 16 of PD array 15 are input, successively via the corresponding bump electrodes 17, conductive members 21 of first wiring substrate 20, conductive members 26 of second wiring substrate 25, and bump electrodes 31, into signal processing element 30. The necessary signal processing is then carried out on the detected signals at the signal processing circuit of signal processing element 30.

The effects of this embodiment's wiring substrate and radiation detector shall now be described.

With the wiring substrate used in wiring substrate section 2 of the radiation detector illustrated in Fig. 1 to Fig. 4A and Fig. 4B, the wiring substrate that is used for electrical connection of the radiation detecting section and the signal processing section, etc., in the radiation detector is arranged by two wiring substrates 20 and 25, each having a predetermined glass substrate. In regard to the through holes of the conduction paths that are respectively provided at first and second wiring substrates 20 and 25, through holes 20c and 25c and conductive members 21 and 26 of the respective wiring substrates 20 and 25 are formed so that the through holes differ with respect to each other in position.

With such an arrangement, when viewed in the conduction direction of the detected signals in the wiring substrate, lead glass or other glass material having a radiation shielding function will exist at portions of wiring substrates 20 and 25 at which there are no through holes. Radiation, which has been transmitted through scintillator 10, etc., is thus restrained from being transmitted through the wiring substrate. Also, even at portions at which there are through holes at one of either of wiring substrates 20 and 25, since first wiring substrate 20 and second wiring substrate 25 differ with respect to each other in the positions of the through holes, there will be no through holes at the other of the wiring substrates.

That is, when viewed in the conduction direction of the detected signals, a glass material with radiation shielding function will exist at least at one of the two wiring substrates 20 and 25 at all positions of wiring substrate section 2. A wiring substrate, with which the transmission of radiation is restrained as a whole in the conduction direction, is thus realized.

With the radiation detector using the above-described wiring substrate in wiring substrate section 2, which electrically connects radiation detecting section 1 and signal processing section 3 and transmits the detected signals that are electrical signals, at all positions of wiring substrate section 2, a glass material having a radiation shielding function exists at least at one of either of the two wiring substrates 20 and 25 when viewed in the alignment direction of the respective components of the radiation detector, in the other words, the direction of incidence of radiation onto the radiation detector that substantially matches the conduction direction of the detected signals. A radiation detector, with which the radiation is prevented from becoming incident on the signal processing element and the degradation of reliability and life due to radiation damage can be restrained definitely, is thus realized.

As the glass material used in the glass substrates of wiring substrates 20 and 25 of wiring substrate section 2, a glass material containing lead is preferably used as mentioned above. By using lead glass, the transmission of radiation through wiring substrate section 2 can be restrained effectively. The amount of lead to be contained in the glass material is preferably set as suited in accordance with the degree of radiation shielding function, etc., that is required in the radiation detector. Also, a glass material besides lead glass may be used.

The wiring substrates of the wiring substrate section shown in Fig. 1 and the glass substrates used therein shall now be described.

As described above, in each of wiring substrates 20 and 25, a glass substrate, provided with a through hole for forming a conductive member that is to serve as a conduction path, is used between the input surface at the radiation detecting section 1 side and the output surface at the signal processing section 3 side. As such a glass substrate, for example, a glass substrate, wherein a plurality of through holes are provided by fusing together and integrally forming a plurality of hollow glass members that are open at both ends, may be used.

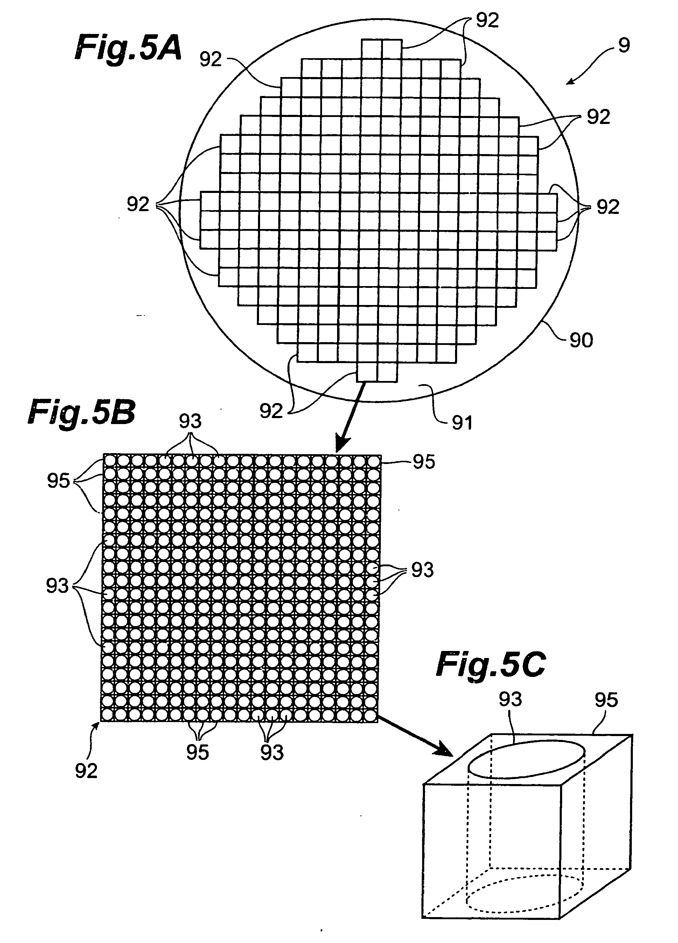

Fig. 5A to Fig. 5C are drawings showing an example of the above-mentioned glass substrate provided with a plurality of through holes. Here, a general arrangement example of a glass substrate with a plurality of through holes is shown. The glass substrate shown in Fig. 5A to Fig. 5C thus differs in shape and arrangement from the wiring substrates used in the radiation detector shown in Fig. 1.

Fig. 5A is a plan view showing the arrangement of the glass substrate, Fig. 5B is a plan view showing the arrangement of a multi-channel member included in the glass substrate, and Fig. 5C is a perspective view showing the arrangement of a glass member included in the multi-channel member. In these Fig. 5A to Fig. 5C, the glass substrate is shown in a state wherein the conductive members, which serve as the conduction paths in a wiring substrate, are not formed.

As shown in Fig. 5A, glass substrate 9 has a capillary substrate 90. Capillary substrate 90 includes a plurality of multi-channel members 92, each having a plurality of through holes 93. Multi-channel members 92 are fused to each other and formed integrally while being positioned two-dimensionally at the inner side of a peripheral member 91 that is formed of a glass material.

As shown in Fig. 5B and Fig. 5C, each multi-channel member 92 is formed by mutually fusing and integrally forming a plurality of hollow glass members 95, which are open at both ends, and has a rectangular shape (for example, of a size of approximately 1000µm × 1000µm) as viewed in the direction perpendicular to the upper surface and the lower surface of capillary substrate 90. Each of the openings of each through hole 93 exhibits a circular shape. The inner diameter of through hole 93 is, for example, approximately 6µm.

As peripheral member 91 and a glass member 95, which comprise capillary substrate 90, a glass material with radiation shielding function, such as a lead glass material, is used, as it was mentioned above in regard to the radiation detector.

As each of wiring substrates 20 and 25 of the radiation detector shown in Fig. 1, a substrate, wherein conductive members, which are to serve as conduction paths, are formed in the through holes of a glass substrate having the arrangement shown in Fig. 5A to Fig. 5C, may be used. That is, with a glass substrate with such an arrangement, the shape of the substrate and the number, positions, etc., of the through holes are set according to the arrangement of the radiation detector. Then by forming conductive members, which are to serve as conduction paths, in the through holes provided in the glass substrate and then forming electrical wiring patterns, each comprised with the required electrodes and wirings, on the respective surfaces, the wiring substrates with arrangements such as those shown in Fig. 3A, Fig. 3B, Fig. 4A, and Fig. 4B are obtained.

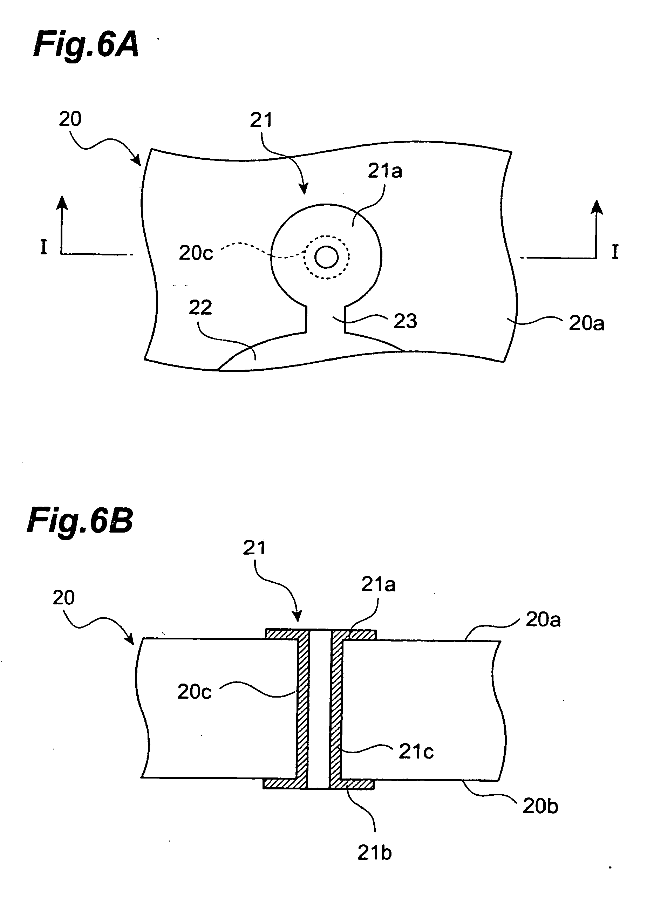

Fig. 6A and Fig. 6B are drawings showing an example of the arrangement of a conductive member provided in a through hole of a wiring substrate, with Fig. 6A being a top view and Fig. 6B being a section taken on arrows I-I. Here, the arrangement of a conductive member 21, which is a conduction path, is illustrated using first wiring substrate 20 (see Fig. 3A and Fig. 3B) as an example.

A plurality (for example, 4 × 4 = 16) of through holes 20c are formed and arrayed two-dimensionally in first wiring substrate 20. As shown in Fig. 6B, each through hole 20c is formed to have a circular cross-sectional shape with an axis perpendicular to input surface 20a and output surface 20b of wiring substrate 20 as its central axis.

With the arrangement example shown in Fig. 6A and Fig. 6B, conductive member 21, which provides electrical connection between input surface 20a and output surface 20b, is provided as a member that is formed on the inner wall of a through hole 20c. That is, a conducting portion 21c is formed on the inner wall of through hole 20c. Also at an outer peripheral portion of through hole 20c on input surface 20a is formed an input portion 21a, which is continuous with conducting portion 21c. At an outer peripheral portion of through hole 20c on output surface 20b is formed an output portion 21b, which is continuous with conducting portion 21c. Conductive member 21, which is to serve as a conduction path of first wiring substrate 20, is thus arranged by conducting portion 21c, input portion 21a, and output portion 21b.

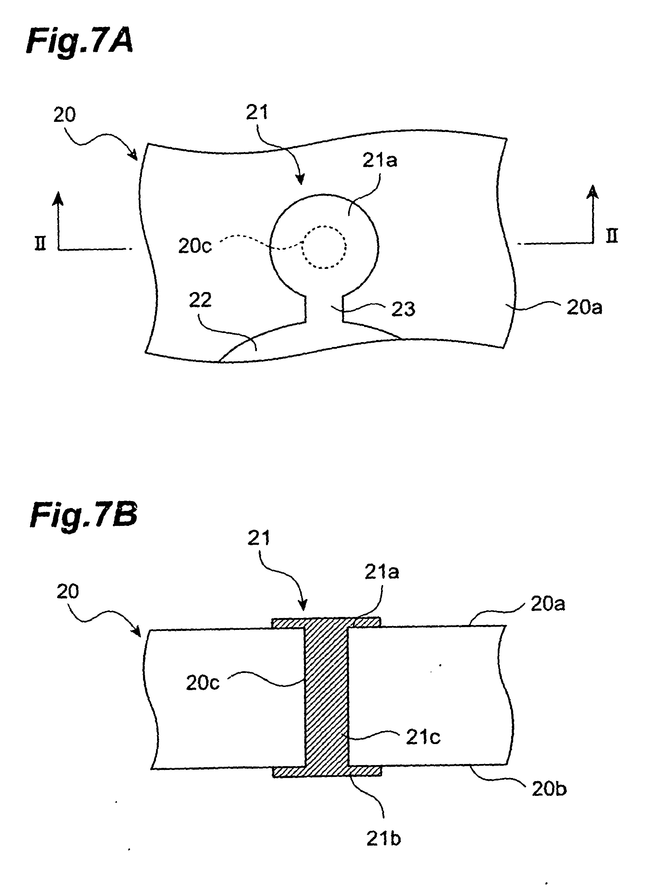

Fig. 7A and Fig. 7B are drawings showing another example of the arrangement of a conductive member provided in a through hole of a wiring substrate, with Fig. 7A being a top view and Fig. 7B being a section taken on arrows II-II. Here, as with Fig. 6A and Fig. 6B, the arrangement of a conductive member 21, which is a conduction path, is illustrated using first wiring substrate 20 as an example.

A plurality of through holes 20c are formed and arrayed two-dimensionally in first wiring substrate 20. As shown in Fig. 7B, each through hole 20c is formed to have a circular cross-sectional shape with an axis perpendicular to input surface 20a and output surface 20b of wiring substrate 20 as its central axis.

With the arrangement example shown in Fig. 7A and Fig. 7B, conductive member 21, which provides electrical connection between input surface 20a and output surface 20b, is provided as a member that fills the interior of a through hole 20c. That is, the interior of through hole 20c is filled with a conducting portion 21c. Also at an outer peripheral portion of through hole 20c on input surface 20a is formed an input portion 21a, which is continuous with conducting portion 21c. At an outer peripheral portion of through hole 20c on output surface 20b is formed an output portion 21b, which is continuous with conducting portion 21c. Conductive member 21, which is to serve as a conduction path of first wiring substrate 20, is thus arranged by conducting portion 21c, input portion 21a, and output portion 21b.

As the conductive members to be formed as conduction paths in a glass substrate having a plurality of through holes, for example, the arrangements shown in Fig. 6A, Fig. 6B, Fig. 7A, and Fig. 7B may be used. The positions of the conduction paths in the glass substrate that is to serve as a wiring substrate is preferably set in accordance with the arrangement of the radiation detector. As such an arrangement, there is the arrangement wherein conductive members are formed upon selecting, from among the plurality of through holes, the through holes at the positions at which conduction paths are required by means of a mask, etc. Also, an arrangement, wherein through holes are provided selectively just at the positions at which conduction paths are required, may be used instead.

The glass substrate used in a wiring substrate is not limited to the arrangement illustrated in Fig. 5A to Fig. 5C and other arrangements may be used instead. With the example of Fig. 5A to Fig. 5C, a plurality of glass members, each having a through hole, are formed integrally to form a multi-channel member, and a plurality of multi-channel members are formed integrally to form a capillary substrate. A capillary substrate may be formed integrally from a plurality of the glass members instead. Also in regard to the shape and alignment of each glass member and multi-channel member, the existence or non-existence, alignment, etc., of the through holes in the respective members, etc., an arrangement that is favorable in accordance with the positions of the conduction paths is preferably used. In regard to the arrangement of the through holes, the cross-sectional shape thereof may be a rectangular shape or other polygonal shape besides a circular shape.

A method of manufacturing the wiring substrate and radiation detector shown in Fig. 1 shall now be described in outline along with specific arrangement examples thereof.

First, glass substrates, each formed of lead glass or other glass material with a radiation shielding function and having through holes formed therein at predetermined positions, are prepared. Conductive members, which are to serve as conduction paths, are then formed in the through holes, and electrical wiring patterns, having the required electrodes and wirings, are then formed at the respective surfaces that are to become the input surfaces and the output surfaces to prepare wiring substrates 20 and 25, which are to form the layered wiring substrate to be used in wiring substrate section 2.

Specifically, in regard to the first wiring substrate at the signal input surface side, first wiring substrate 20 is prepared by forming conductive members 21, each comprising conducting portion 21c, input portion 21a, and output portion 21b, at through holes 20c that are provided in a glass substrate and forming electrode pads 22 and wirings 23 on input surface 20a. In regard to the second wiring substrate at the signal output surface side, second wiring substrate 25 is prepared by forming conductive members 26, each comprising conducting portion 26c, input portion 26a, and output portion 26b, at through holes 25c that are provided in a glass substrate and forming wirings 28 on input surface 25a and electrode pads 29 on output surface 25b.

The above-mentioned conductive members and electrical wiring patterns to be formed on the glass substrates may be formed of conductive metal layers that are formed, for example, of titanium nitride (TiN), nickel (Ni), aluminum (Al), chromium (Cr), copper (Cu), silver (Ag), gold (Au), or an alloy of such metals. Such a metal layer may be a single metal layer, a composite film, or a layered film. As a specific method of forming such a layer, a method of providing the glass substrate with a mask of the desired pattern, forming the metal layer by vapor deposition (physical vapor deposition (PVD) or chemical vapor deposition (CVD)), plating, sputtering, etc., and thereafter removing the mask may be used.

Bump electrodes are then formed as necessary on the wiring substrates on which the conductive members and electrical wiring patterns have been formed. With the above-described embodiment, bump electrodes 27 are formed on electrode pads that have been formed at the end parts of wirings 28 on input surface 25a of second wiring substrate 25. First wiring substrate 20 and second wiring substrate 25 are then aligned with respect to each other and mounting via bump electrodes 27 is performed to arrange the layered wiring substrate that is to be wiring substrate section 2.

As the bump material for forming bump electrodes 27, nickel (Ni), copper (Cu), silver (Ag), gold (Au), solder, a resin containing a conductive filler, or a composite material of such materials may for example be used. An under-bump metal (UBM) may be interposed between bump electrodes 27 and the electrode pads on input surface 25a of wiring substrate 25.

When wiring substrate section 2, comprising wiring substrates 20 and 25, has been prepared, an IC chip of signal processing element 30, on which bump electrodes 31 have been formed, is aligned with respect to output portions 26b of conductive members 26 provided on output surface 25b of second wiring substrate 25, and these are connected physically and electrically. Also, PD array 15, having bump electrodes 17 formed thereon, is aligned with respect to electrode pads 22 provided on input surface 20a of first wiring substrate 20, and these are connected physically and electrically. The same description as that of bump electrodes 27 applies in regard to the bump material, etc., of bump electrodes 31 and 17.

Housing 40, on which bump electrodes 44 have been formed, is then aligned with respect to electrode pads 29 provided on output surface 25b of second wiring substrate 25, and these are connected physically and electrically. By the above, input/output operations of signals with respect to an external circuit are enabled via leads 43 that are provided at housing 40. By then mounting scintillator 10 via optical adhesive agent 11 onto light-incident surface 15a of PD array 15, the radiation detector shown in Fig. 1 is obtained.

Here, in regard to PD array 15, which is provided as the semiconductor photodetecting element array in radiation detecting section 1, a PD array of a front surface incidence type, with which the photodiodes are formed on light-incident surface (front surface) 15a, may be used, or a PD array of a back surface incidence type, with which the photodiodes are formed on signal output surface (back surface) 15b may be used. The number, alignment, etc., of the photodiodes that are the photodetecting elements can be set as suited.

Also, as the arrangement for outputting the detected signals from the photodiodes from output surface 15b, an arrangement of wiring patterns formed on output surface 15b or an arrangement of through electrodes formed in PD array 15, etc. may be employed, in accordance with the specific arrangement of the PD array.

With the radiation detector shown in Fig. 1, an arrangement, having scintillator 10, which generates scintillation light upon incidence of radiation, and a PD array 15, which is provided with photodiodes 16 that are the semiconductor photodetecting elements that detect the scintillation light from scintillator 10, is employed as the arrangement of radiation detecting section 1. Such an arrangement is an indirect detection type arrangement, wherein an incident X-ray or other radiation is converted to light of a predetermined wavelength (for example, visible light) by means of scintillator 10 and then detected by an Si-PD array or other semiconductor photodetecting elements.

An arrangement, which is not provided with a scintillator but is provided with semiconductor detecting elements that detect the incident radiation, may be employed instead as the radiation detecting section. Such an arrangement is a direct detection type arrangement, wherein the incident X-ray of other radiation is detected by semiconductor detecting elements formed of CdTe, etc. This corresponds, for example, to an arrangement with which scintillator 10 is removed from the arrangement of Fig. 1 and PD array 15 is replaced by a semiconductor detecting element array.

In regard to the mounting of first wiring substrate 20 and second wiring substrate 25 in wiring substrate section 2, the connection of wiring substrate section 2 with radiation detecting section 1, the connection of wiring substrate section 2 with signal processing section 3, etc., it is preferable to use a direct bonding method of forming electrical connections via bump electrodes as in the above-described embodiment. By thus using metal bump electrodes as the electrical connection means, the respective components can be electrically connected favorably.

Besides such an arrangement using bump electrodes, an arrangement, wherein filling by an underfill resin after making connections with the bump electrodes, an arrangement employing an anisotropic conductive film (ACF) method, an anisotropic conductive paste (ACP) method, or a non-conductive paste (NCP) method may also be used. In regard to the respective substrates, passivation films, formed of an insulating substance, may be formed as necessary in the state in which the electrode pads are open.

### Industrial Applicability

This invention's wiring substrate and radiation detector using the same can be used as a wiring substrate and a radiation detector, with which the transmission of radiation is restrained. That is, with an arrangement wherein a wiring substrate, used for electrical connection between a radiation detecting means and a signal processing means in a radiation detector, etc., is arranged by first and second wiring substrates that are respectively formed of a predetermined glass material having a radiation shielding function and wherein for the conduction paths respectively provided in the first and second wiring substrates, the through holes of the conduction paths are differed with respect to each other in position, the transmission of radiation from the signal input surface to the signal output surface is restrained by the glass material at portions of the wiring substrates without any through holes.

Also with this arrangement, even at portions where there are through holes at one of the wiring substrates, there are no through holes at the other wiring substrate. That is, at all positions of the wiring substrates, the glass material with radiation shielding function exists at least at one of the first and second wiring substrates. A wiring substrate, with which the transmission of radiation is restrained as a whole, is thus realized.

Also with a radiation detector, wherein the wiring substrate of such arrangement is applied to a wiring substrate section, the glass material with the radiation shielding function exists at least at one of the two wiring substrates at all positions of the wiring substrate section. A radiation detector, with which radiation is prevented from becoming incident on a signal processing element and degradation of reliability and life due to radiation damage is thereby restrained, is thus realized.

## Claims

1. A wiring substrate (2), having a conduction path that guides an electrical signal between a signal input surface (20a) and a signal output surface (25b),
the wiring substrate (2) comprising at least a first wiring substrate (20), disposed at the signal input surface side (20a), and a second wiring substrate (25), connected to the first wiring substrate (20) at the signal output surface side (25b), each wiring substrate respectively comprising a glass substrate, formed of a glass material having a radiation shielding function and provided with a through hole (20c, 25c), and a conductive member (21, 26), disposed in the through hole and functioning as the conduction path by providing electrical connection between the input surface (20a) and the output surface (25b), and
wherein in the view in the conduction direction from the signal input surface (20a) to the signal output surface (25b), the position of the through hole (20c) in the first wiring substrate (20) differs from the position of the through hole (25c) in the second wiring substrate (25), and wherein the conductive member (21) in the first wiring substrate (20) is electrically connected to the conductive member (26) in the second wiring substrate (25) by a bump electrode (27).

2. The wiring substrate according to Claim 1, wherein each of the first wiring substrate (20) and the second wiring substrate (25) is formed of the glass material that contains lead.

3. The wiring substrate according to Claim 1 or 2, wherein the conductive member (21, 26) of each of the first wiring substrate (20) and second wiring substrate (25) is formed and disposed on the inner wall of the through hole (20c, 25c) that is provided in the glass substrate.

4. The wiring substrate according to Claim 1 or 2, wherein the conductive member (21, 26) of each of the first wiring substrate (20) and second wiring substrate (25) is disposed by filling the interior of the through hole (20c, 25c) that is provided in the glass substrate.

5. The wiring substrate according to any of Claims 1 through 4, wherein the glass substrate of each of the first wiring substrate (20) and second wiring substrate (25) is a glass substrate, wherein a plurality of the through holes are provided by fusing together and integrally forming a plurality of hollow glass members that are open at both ends.

6. A radiation detector comprising:
a radiation detecting means (1), outputting a detected signal upon detecting radiation made incident thereon;
a signal processing means (3), processing the detected signal from the radiation detecting means (1); and
a wiring substrate section (2), having the wiring substrate (2) according to any of Claims 1 through 5 that is provided with the conduction path that guide the detected signal between the signal input surface (20a) and the signal output surface (25b), the radiation detecting means (1) and the signal processing means (3) being connected to the signal input surface (20a) and the signal output surface (25b), respectively; and
wherein the radiation detecting means (1), the wiring substrate section (2), and the signal processing means (3) are positioned in that order along a predetermined alignment direction that matches the conduction direction in the wiring substrate (2).

7. The radiation detector according to Claim 6, wherein the radiation detecting means (1) comprises a scintillator (10), generating scintillation light upon incidence of radiation; and a semiconductor photodetecting element (15), detecting the scintillation light from the scintillator.

8. The radiation detector according to Claim 6, wherein the radiation detecting means (1) comprises a semiconductor detecting element (15), detecting radiation made incident thereon.

9. The radiation detector according to any of Claims 6 through 8, wherein at least one of either the combination of the wiring substrate section (2) and the radiation detecting means (1) or the combination of the wiring substrate section (2) and the signal processing means (3) is electrically connected via a bump electrode (17, 31).

## Patentansprüche

1. Verdrahtungssubstrat (2), welches eine Leiterbahn umfasst, die ein elektrisches Signal zwischen einer Signaleingangsfläche (20a) und einer Signalausgangsfläche (25b) leitet,
wobei das Verdrahtungssubstrat (2) wenigstens ein erstes an der Signaleingangsflächenseite (20a) angeordnetes Verdrahtungssubstrat (20) und ein mit dem ersten Verdrahtungssubstrat (20) an der Signalausgangsfläche (25b) verbundenes zweites Verdrahtungssubstrat (25) umfasst, wobei jedes Verdrahtungssubstrat jeweils ein Glassubstrat umfasst, welches aus einem Glasmaterial mit einer Strahlenschutzfunktion gebildet ist und mit einem Durchgangsloch (20c, 25c) und einem in dem Durchgangsloch vorgesehenen Leiterelement (21, 26) versehen ist, welches als die Leiterbahn dient, indem es eine elektrische Verbindung zwischen der Eingangsfläche (20a) und der Ausgangsfläche (25b) vorsieht,
und wobei sich bei Ansicht in Leiterrichtung von der Signaleingangsfläche (20a) zu der Signalausgangsfläche (25b) die Position des Durchgangslochs (20c) in dem ersten Verdrahtungssubstrat (20) von der Position des Durchgangslochs (25c) in dem zweiten Verdrahtungssubstrat (25) unterscheidet, und wobei das Leiterelement (21) in dem ersten Verdrahtungssubstrat (20) mit dem Leiterelement (26) in dem zweiten Verdrahtungssubstrat (25) durch eine Buckelelektrode (27) elektrisch verbunden ist.

2. Verdrahtungssubstrat nach Anspruch 1, wobei jedes des ersten Verdrahtungssubstrats (20) und des zweiten Verdrahtungssubstrats (25) aus dem Glasmaterial gebildet ist, welches Blei enthält.

3. Verdrahtungssubstrat nach Anspruch 1 oder 2, wobei das Leiterelement (21, 26) jedes des ersten Verdrahtungssubstrats (20) und des zweiten Verdrahtungssubstrats (25) an der Innenwand des in dem Glassubstrat vorgesehenen Durchgangslochs (20c, 25c) gebildet und angeordnet ist.

4. Verdrahtungssubstrat nach Anspruch 1 oder 2, wobei das Leiterelement (21, 26) jedes des ersten Verdrahtungssubstrats (20) und des zweiten Verdrahtungssubstrats (25) durch Füllen des Inneren des in dem Glassubstrat vorgesehenen Durchgangslochs (20c, 25c) vorgesehen ist.

5. Verdrahtungssubstrat nach einem der Ansprüche 1 bis 4, wobei das Glassubstrat jedes des ersten Verdrahtungssubstrats (20) und des zweiten Verdrahtungssubstrats (25) ein Glassubstrat ist, wobei eine Mehrzahl von Durchgangslöchern durch Zusammenschmelzen und integrales Formen einer Mehrzahl hohler Glaselemente vorgesehen ist, welche an beiden Enden offen sind.

6. Strahlungsdetektor, umfassend:
ein Strahlungserfassungsmittel (1), welches ein erfasstes Signal ausgibt, nachdem Strahlung darauf eingefallen ist;
ein Signalverarbeitungsmittel (3), welches das von dem Strahlungserfassungsmittel (1) erfasste Signal verarbeitet; und
einen Verdrahtungssubstratabschnitt (2) mit dem Verdrahtungssubstrat (2) nach einem der Ansprüche 1 bis 5, welches mit der Leiterbahn versehen ist, welche das erfasste Signal zwischen der Signaleingangsfläche (20a) und
einer Signalausgangsfläche (25b) leitet, wobei das Strahlungserfassungsmittel (1) und das Signalverarbeitungsmittel (3) mit der Signaleingangsfläche (20a) beziehungsweise der Signalausgangsfläche (25b) verbunden sind; und
wobei das Strahlungserfassungsmittel (1), der Verdrahtungssubstratabschnitt (2) und das Signalverarbeitungsmittel (3) in dieser Reihenfolge entlang einer vorbestimmten Ausrichtung positioniert sind, welche der Leitungsrichtung in dem Verdrahtungssubstrat (2) entspricht.

7. Strahlungsdetektor nach Anspruch 6, wobei das Strahlungserfassungsmittel (1) einen Szintillator (10) umfasst, der beim Einfall von Strahlung Szintillationslicht erzeugt; und ein Halbleiter-Photodetektorelement (15) umfasst , welches das Szintillationslicht des Szintillators erfasst.

8. Strahlungsdetektor nach Anspruch 6, wobei das Strahlungserfassungsmittel (1) ein Halbleiter-Detektorelement (15) umfasst, welches darauf einfallende Strahlung erfasst.

9. Strahlungsdetektor nach einem der Ansprüche 6 bis 8, wobei wenigstens eine von der Kombination aus dem Verdrahtungssubstratabschnitt (2) und dem Strahlungserfassungsmittel (1) oder der Kombination aus dem Verdrahtungssubstratabschnitt (2) und dem Signalverarbeitungsmittel (3) mittels einer Buckelelektrode (17, 31) elektrisch verbunden ist.

## Revendications

1. Substrat de câblage (2), ayant un chemin de conduction qui guide un signal électrique entre une surface (20a) d'entrée de signal et une surface (25b) de sortie de signal,
le substrat de câblage (2) comportant au moins un premier substrat de câblage (20) disposé du côté de la surface d'entrée de signal (20a), et un second substrat de câblage (25) connecté au premier substrat de câblage (20) du côté de la surface de sortie de signal (25b), chaque substrat de câblage comprenant respectivement un substrat de verre, formé d'une matière vitreuse ayant une fonction de blindage contre les rayonnements et pourvue d'un trou traversant (20c, 25c), et un élément conducteur (21, 26) disposé dans le trou traversant et fonctionnant en tant que chemin de conduction en établissant une connexion électrique entre la surface d'entrée (20a) et la surface de sortie (25b), et
dans lequel, dans la perspective dans la direction de conduction de la surface d'entrée de signal (20a) vers la surface de sortie de signal (25b), la position du trou traversant (20c) dans le premier substrat de câblage (20) diffère de la position du trou traversant (25c) dans le second substrat de câblage (25), et dans lequel l'élément conducteur (21) dans le premier substrat de câblage (20) est connecté électriquement à l'élément conducteur (26) dans le second substrat de câblage (25) par une électrode à bosse (27).

2. Substrat de câblage selon la revendication 1, dans lequel chacun du premier substrat de câblage (20) et du second substrat de câblage (25) est formé de la matière du type verre qui contient du plomb.

3. Substrat de câblage selon la revendication 1 ou 2, dans lequel l'élément conducteur (21, 26) de chacun du premier substrat de câblage (20) et du second substrat de câblage (25) est formé et disposé sur la paroi intérieure du trou traversant (20c, 25c) qui est situé dans le substrat de verre.

4. Substrat de câblage selon la revendication 1 ou 2, dans lequel l'élément conducteur (21, 26) de chacun du premier substrat de câblage (20) et du second substrat de câblage (25) est disposé par remplissage de l'intérieur du trou traversant (20c, 25c) qui est situé dans le substrat de verre.

5. Substrat de câblage selon l'une quelconque des revendications 1 à 4, dans lequel le substrat de verre de chacun du premier substrat de câblage (20) et du second substrat de câblage (25) est un substrat de verre, dans lequel de multiples trous traversants sont prévus par fusion ensemble et formation intégrée de multiples éléments creux en verre qui sont ouverts aux deux extrémités.

6. Détecteur de rayonnement comportant :
un moyen (1) de détection de rayonnement, délivrant en sortie un signal détecté à la suite de la détection d'un rayonnement qui lui est incident ;
un moyen (3) de traitement de signal, traitant le signal détecté provenant du moyen (1) de détection du rayonnement ; et
une section (2) à substrat de câblage, ayant le substrat de câblage (2) selon l'une quelconque des revendications 1 à 5, qui est pourvu du chemin de conduction qui guide le signal détecté entre la surface (20a) d'entrée de signal et la surface (25b) de sortie de signal, le moyen (1) de détection du rayonnement et le moyen (3) de traitement de signal étant connectés à la surface (20a) d'entrée de signal et à la surface (25b) de sortie de signal, respectivement ; et
dans lequel le moyen (1) de détection de rayonnement, la section à substrat de câblage (2) et le moyen (3) de traitement de signal sont positionnés dans cet ordre, suivant une direction d'alignement prédéterminée qui correspond à la direction de conduction dans le substrat de câblage (2).

7. Détecteur de rayonnement selon la revendication 6, dans lequel le moyen (1) de détection de rayonnement comporte un scintillateur (10), générant une lumière de scintillation à la suite de l'incidence d'un rayonnement ; et un élément (15) de photodétection à semi-conducteur, détectant la lumière de scintillation provenant du scintillateur.

8. Détecteur de rayonnement selon la revendication 6, dans lequel le moyen (1) de détection de rayonnement comporte un élément (15) de détection à semi-conducteur, détectant un rayonnement qui lui est incident.

9. Détecteur de rayonnement selon l'une quelconque des revendications 6 à 8, dans lequel au moins l'une de la combinaison de la section à substrat de câblage (2) et du moyen de détection du rayonnement (1), ou de la combinaison de la section à substrat de câblage (2) et du moyen de traitement (3) de signal est connectée électriquement par l'intermédiaire d'une électrode à bosse (17, 31).
